# FASCICULE DE BREVET EUROPEEN

(11) **EP 0 567 372 B1**
(45) Date de publication et mention de la délivrance du brevet: **09.11.1994**
(21) Numéro de dépôt: 93400972.1
(22) Date de dépôt: 14.04.1993
(51) Int. Cl.: H05K 9/00

(54) **Système de blindage de feuillure de porte, notamment pour une porte de cage de Faraday**
Abschirmsystem für Türweg, insbesondere für Faradaykäfig
Shielding system in door frame, especially for a door on a Faraday cage

(30) Priorité: 22.04.1992 FR 9204930
(43) Date de publication de la demande: 27.10.1993
(73) Titulaire: SIEPEL - Société Industrielle d'Etudes et Protection Electronique, 56470 La Trinité-sur-Mer (FR)
(72) Inventeur: Ruelle, Philippe, F-56400 Pluneret (FR); Le Baron, Philippe, F-56470 La Trinite-sur-Mer (FR)
(74) Mandataire: Jaunez, Xavier

(56) Documents cités:
- EP-A- 0 269 126
- EP-A- 0 320 592
- US-A- 4 817 337

## Description

La présente invention concerne le blindage des feuillures de porte, notamment pour des portes de cages de Faraday.

Le terme "blindage" utilisé ci-dessus est relatif à l'étanchéité aux ondes électromagnétiques.

Dans le cas particulier des cages de Faraday, la principale propriété recherchée est que la cage forme une barrière isolante aux ondes électromagnétiques entre l'intérieur et l'extérieur de ladite cage, soit pour éviter qu'un signal électromagnétique émis à l'intérieur de la cage de Faraday puisse être capté ou se propage à l'extérieur, soit à l'inverse pour protéger l'intérieur de la cage contre une influence électromagnétique extérieure.

L'étanchéité électromagnétique doit donc être étudiée au niveau des raccordements des éléments assemblés constituant la cage de Faraday, et en particulier au niveau de la feuillure de la porte de la cage.

On utilise alors en général un système de blindage de feuillure de porte, comportant deux profilés rigides homologues respectivement fixés au battant et au dormant, dont l'un a une section en forme de U définissant un espace intérieur dans lequel pénètre, à la fermeture de la porte, une nervure principale solidaire de l'autre profilé, ainsi que deux profilés souples cintrés disposés dans cet espace intérieur et entre lesquels vient s'insérer la nervure principale précitée pour assurer la continuité électrique lorsque la porte est fermée.

On connaît de tels systèmes qui utilisent ainsi une nervure principale plate (délimitée par deux plans parallèles) venant s'insérer, à la fermeture de la porte, entre deux profilés souples cintrés fixés sur les branches latérales du profilé en U (du côté intérieur à celles-ci), comme décrit dans les documents US-A-4 817 337 et EP-A-0 269 126. Chacun de ces profilés cintrés, qui est analogue à une lame-ressort, comporte une portion de contact qui est bombée, et un bord d'extrémité plat servant à la fixation (en général par vissage) à l'intérieur du profilé en U.

Les systèmes du type précité présentent cependant certains inconvénients et/ou limitations.

En effet, la nervure principale est en générale relativement mince, pour éviter d'exercer une compression excessive sur les profilés souples cintrés chaque fois que l'on ferme la porte. De ce fait, on trouve une fente relativement large entre les faces de la nervure principale et les faces intérieures des ailes du profilé en U, ce qui est défavorable pour la qualité de l'étanchéité électromagnétique, même si l'on prévoit de rajouter au fond de l'espace intérieur du profilé en U un joint d'étanchéité aux hyperfréquences, joint contre lequel vient porter le bord d'extrémité libre de la nervure principale à la fermeture de la porte.

De plus, lorsque la porte est fermée, chaque face de la nervure principale est tangente à la portion de contact bombée du profilé cintré correspondant, de sorte que le contact est essentiellement ponctuel (c'est-à-dire le long d'une ligne de contact parallèle à la direction générale des profilés) : la continuité électrique risque alors d'être déficiente lorsque le contact n'est pas parfait.

Enfin, le montage de tels systèmes reste fastidieux, dans la mesure où il faut tout d'abord fixer un joint étanche aux hyperfréquences au fond du profilé en U, puis fixer, par exemple par vissage ou collage, chaque profilé cintré à l'intérieur du profilé en U, ces opérations devant être effectuées dans un espace dont l'accessibilité frontale se réduit à une fente d'environ un centimètre de large, et ce sur des longueurs qui peuvent atteindre cinq mètres.

On a également proposé un système de blindage analogue dans lequel la nervure principale est de section triangulaire (la description indique que l'angle au sommet est compris entre 25° et 35°) pour éviter un coincement par les deux ressorts de contact cintrés, comme décrit dans le document EP-A-0 320 592. Le fait que les deux faces latérales de la nervure soient convergentes ne modifie pas le contact qui là encore est essentiellement ponctuel. Cet agencement présente un inconvénient supplémentaire par rapport aux systèmes précédents, dans la mesure où un risque de déséquilibre de la compression exercée est introduit.

L'invention a précisément pour but de résoudre ce problème, en concevant un système de blindage ne présentant pas les inconvénients et/ou limitations précités des systèmes connus.

L'invention a ainsi pour objet de réaliser un système de blindage de feuillure de porte permettant d'obtenir une excellente étanchéité aux ondes électromagnétiques, tout en favorisant la qualité de la continuité électrique lorsque la porte est fermée, ce qui rend ce système tout spécialement intéressant dans le cas particulier des cages de Faraday.

L'invention a également pour objet de réaliser un système de blindage dont la structure est à la fois simple, robuste, et aisée à monter, même si les profilés concernés présentent une longueur importante (par exemple cinq mètres).

Il s'agit plus particulièrement d'un système de blindage de feuillure de porte, notamment pour une porte de cage de Faraday, comportant deux profilés rigides homologues respectivement fixés au dormant et au battant, dont l'un a une section en forme de U définissant un espace intérieur dans lequel pénètre, à la fermeture de la porte, une nervure principale solidaire de l'autre profilé, ainsi que deux profilés souples cintrés disposés dans ledit espace intérieur et entre lesquels vient s'insérer ladite nervure principale pour assurer la continuité électrique lorsque la porte est fermée, caractérisé par le fait que la nervure principale présente une portion de base large se raccordant par une portion intermédiaire à une portion d'extrémité effilée, lesdites portions étant agencées de telle façon que, lorsque la porte est fermée, chacun des profilés souples cintrés contacte simultanément la portion intermédiaire et la portion d'extrémité de la nervure principale.

Ainsi, grâce à la largeur importante de la portion de base de la nervure principale, on obtient une excellente étanchéité aux ondes électromagnétiques, et ce sans risque d'exercer une compression excessive sur les profilés cintrés formant lames de contact à la fermeture de la porte, grâce à la portion d'extrémité effilée.

De préférence, la portion intermédiaire de la nervure principale forme un raccordement progressif définissant une large plage de contact pour chacun des profilés souples cintrés. Bien que cette mesure ne soit aucunement indispensable (le raccordement pourrait par exemple se faire par un épaulement), le raccordement progressif reste cependant avantageux tant au niveau de la qualité du contact obtenu qui assure une très bonne continuité électrique, qu'au niveau des sollicitations mécaniques exercées sur les profilés souples cintrés à chaque fermeture de la porte.

Avantageusement encore, les deux profilés souples cintrés sont auto-portés dans l'espace intérieur du profilé en U.

Ces profilés peuvent être alors insérés en bout (ou encore frontalement), et mis en place aisément, même pour de grandes longueurs, sans avoir à prévoir une fixation par vissage ou collage.

De préférence alors, le profilé en U présente en outre une nervure centrale au fond de l'espace central, de part et d'autre de laquelle passe un bord d'extrémité de chacun des profilés souples cintrés, ladite nervure centrale assurant ainsi le maintien et le centrage desdits profilés souples cintrés. En particulier, la nervure centrale est effilée depuis sa base, de façon à procurer un guidage facilitant une éventuelle mise en place frontale des profilés souples cintrés.

Avantageusement encore, chaque profilé souple cintré comporte une portion centrale de contact qui est bombée, et deux bords d'extrémité dont l'un est en appui contre la base de la nervure centrale, tandis que l'autre est reçu dans une gorge associée du profilé en U prévue pour empêcher une extraction frontale dudit profilé souple cintré. En particulier, les bords d'extrémité de chaque profilé souple cintré sont relevés, de façon à définir au niveau des pliages correspondants deux arêtes longitudinales d'appui et de contact.

Il est également intéressant que le système de blindage comporte en outre au moins un joint d'étanchéité aux hyperfréquences.

Il est par exemple prévu un joint d'étanchéité monté au fond d'une gorge définie par la nervure principale et une aile d'appui du profilé correspondant, ledit joint étant alors contacté, lorsque la porte est fermée, par une branche du profilé en U. En sus ou en variante, il peut être aussi prévu un joint d'étanchéité monté sur une aile latérale solidaire d'une branche du profilé en U, ledit joint étant alors contacté, lorsque la porte est fermée, par un rebord saillant du profilé portant la nervure principale.

Il convient d'observer que le montage de ce ou ces joints d'étanchéité aux hyperfréquences n'est aucunement prévu au fond du profilé en U comme c'était le cas pour les systèmes de blindages connus, mais au niveau de zones dont l'accès est plus aisé.

D'autres caractéristiques et avantages de l'invention apparaîtront plus clairement à la lumière de la description qui va suivre et du dessin annexé, concernant un mode de réalisation particulier, en référence aux figures où:
- la figure 1 est une coupe illustrant un système de blindage conforme à l'invention, dans la position porte fermée ;
- la figure 2 est une coupe, à plus petite échelle, du système précédent, dans une position précédant la fermeture de la porte (la nervure principale n'est pas encore insérée entre les deux profilés souples cintrés qui sont ici auto-portés dans le profilé U) ;
- la figure 3 illustre en perspective un profilé correspondant aux profilés souples cintrés précités, qui sont auto-portés, un tel profilé pouvant notamment être simplement glissé en bout dans le profilé en U pour sa mise en place.

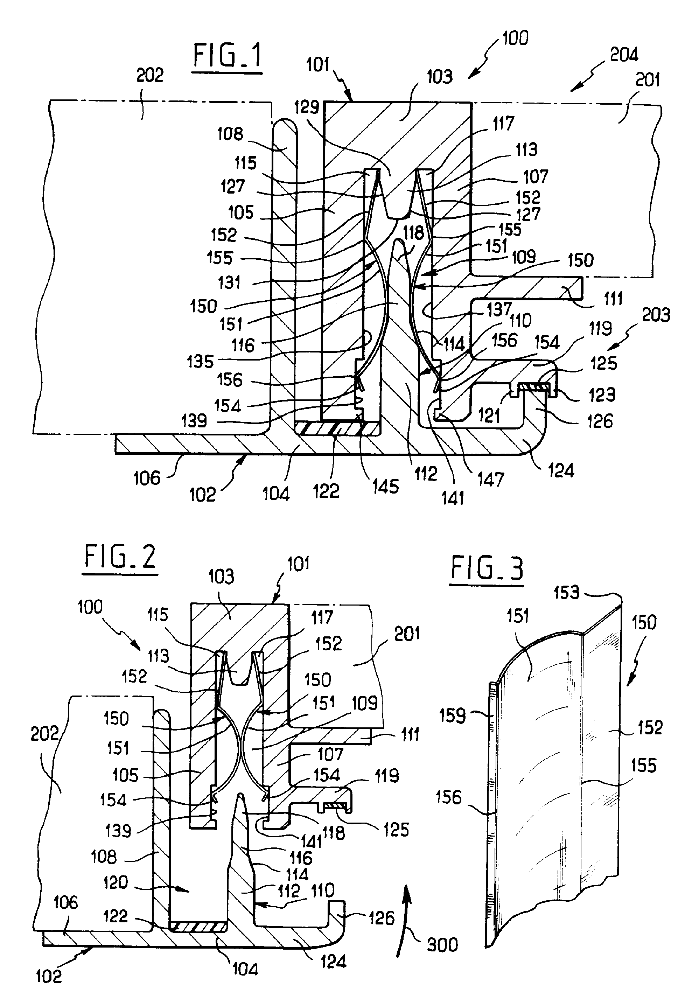

Les figures 1 et 2 illustrent un système de blindage de feuillure de porte 100 conforme à l'invention, un tel système pouvant être avantageusement utilisé pour une porte de cage de Faraday. Le système de blindage 100 comporte deux profilés rigides homologues 101, 102, par exemple réalisés en laiton, qui sont respectivement fixés à des panneaux 201, 202, formant ici respectivement le dormant et le battant de la porte (le côté extérieur de la cage est ici référencé 203, et le côté intérieur 204).

Le profilé 101 a une section en forme de U définissant un espace intérieur 109 dans lequel pénètre, à la fermeture de la porte, une nervure principale 110 solidaire de l'autre profilé 102. Deux profilés souples cintrés 150 sont disposés dans cet espace intérieur 109, et la nervure principale 110 vient s'insérer entre ces profilés souples cintrés lorsque la porte est fermée, pour assurer la continuité électrique.

Conformément à un aspect essentiel de l'invention, la nervure principale 110 présente une portion de base large 112 se raccordant, par une portion intermédiaire 114 à une portion d'extrémité effilée 116, lesdites portions étant agencées de telle façon que, lorsque la porte est fermée, chacun des profilés souples cintrés 150 contacte simultanément la portion intermédiaire 114 et la portion d'extrémité 116 de la nervure principale 110.

La portion de base 112 de la nervure principale 110 présente une largeur importante, qui sera choisie aussi grande que possible, tout en restant compatible avec la largeur de l'espace central 109 du profilé en U 101, ce qui permet de conférer une excellente étanchéité aux ondes électro-magnétiques. La portion d'extrémité effilée 116 vient quant à elle s'insérer entre les deux profilés souples cintrés 150, et sa largeur est plus faible que celle de la portion de base, ce qui permet d'éviter d'exercer une compression excessive sur les profilés cintrés 150 formant lames de contact lors de la fermeture de la porte.

La portion intermédiaire 114 de la nervure principale 110 forme ici un raccordement progressif, défini par deux plans inclinés, ce qui permet d'organiser une large plage de contact pour chacun des profilés souples cintrés 150, ainsi que cela est bien visible sur la figure 1. On pourra naturellement en variante prévoir un raccordement progressif incurvé, épousant autant que faire ce peut la courbure des profilés cintrés 150 ; on pourra à l'inverse prévoir un raccordement par un épaulement entre la portion de base 112 et la portion effilée 116, le contact avec la portion intermédiaire constitué par cet épaulement étant dans ce cas réduit au contact sur l'arête extérieure dudit épaulement (ce dernier mode de réalisation est toutefois moins favorable tant sur le plan des sollicitations mécaniques exercées, que pour la qualité de la continuité électrique). Il convient de noter que la portion effilée 116 est ici délimitée par deux plans parallèles, et se termine par un bord d'extrémité 118 encore plus étroit, à la manière d'une lame de couteau, pour avoir une insertion progressive douce entre les profilés cintrés 150 lors de la fermeture de la porte.

Le profilé en U 101 comporte en outre une base 103, de laquelle partent deux branches latérales 105, 107, entre lesquelles est défini l'espace intérieur 109 précité. Le profilé 101 est ici relié au dormant 201 de la porte, avec un appui complémentaire conféré par une aile saillante 111. De la même façon, le profilé 102 portant la nervure principale 110 comporte une embase 104, de laquelle partent deux ailes orthogonales 106, 108 associées à l'appui du battant 202 de la porte. Il va de soi que l'on pourrait en variante associer le profilé en U au battant de la porte, et l'autre profilé au dormant.

Conformément à une autre caractéristique de l'invention, les deux profilés souples cintrés 150 sont auto-portés dans l'espace intérieur 109 du profilé en U 101. Cette caractéristique, qui est très avantageuse dans la pratique, peut être mise en oeuvre grâce d'une part à l'agencement intérieur particulier du profilé en U et d'autre part au profil spécial de chacun des deux profilés cintrés 150 formant lame ressort.

Le profilé en U 101 présente ici une nervure centrale 113 au fond de l'espace central 109, nervure dont la base 129 saille de la base 103 du profilé en U, et de part et d'autre de laquelle passe un bord d'extrémité 152 de chacun des profilés souples 150 mis en place. La nervure centrale 113 assure ainsi le maintien et le centrage des profilés souples cintrés 150. A ce titre, il est intéressant que la nervure centrale 113 soit légèrement effilée depuis sa base 129, ce que l'on peut voir ici avec les facettes inclinées 127 de cette nervure centrale 113, de façon à procurer un guidage facilitant une éventuelle mise en place frontale des profilés souples cintrés 150 dans le profilé en U 101. L'extrémité libre 131 de la nervure centrale 113 définit ainsi un espace de faible largeur avec le bord libre d'extrémité 118 de la nervure principale 110, lorsque la porte est fermée. Il convient en outre de noter que la nervure centrale remplit également une fonction de remplissage de matière dans l'espace central du profilé en U, ce qui est également favorable pour l'étanchéité électromagnétique lorsque la porte est fermée.

Les faces intérieures 135 et 137 des deux branches 105 et 107 du profilé en U 101 sont essentiellement lisses, à l'exception toutefois de leur zone proche de l'ouverture dudit profilé : on a en effet prévu deux gorges 139 et 141, dont la direction est parallèle à la direction principale des profilés du système de blindage, chacune des ces gorges pouvant recevoir un bord d'extrémité 154 du profilé souple cintré 150. Ainsi que cela est mieux visible sur la figure 3, chacun des profilés souples cintrés 150 comporte en effet une portion centrale de contact 151 qui est bombée, et deux bords d'extrémité 152, 154, qui sont ici relevés par suite de deux pliages effectués parallèlement à la direction principale du profilé. Ces pliages, référencés 155 et 156, définissent ainsi deux arêtes longitudinales d'appui et de contact pour les profilés souples cintrés 150, ainsi que cela est bien visible sur les figures 1 et 2. Chacun des profilés souple 150 est ainsi maintenu à l'intérieur du profilé en U 101 en étant coincé par sa branche 152 qui est en appui contre la nervure centrale 113 du profilé en U. De préférence, ainsi que cela est visible sur la figure 2, les deux profilés souples 150 sont au contact l'un de l'autre par leur portion centrale bombée 151 lorsque la nervure principale 110 n'est pas insérée, ce qui favorise un maintien naturel de ces deux profilés souples cintrés. Chaque profilé souple cintré 150 est en butée contre le fond de l'espace intérieur 109 par son arête d'extrémité 153, et, lors de l'insertion de la nervure principale 110, l'arête d'appui 156 peut se déplacer axialement dans la gorge associée 139 ou 141 par suite de la déformation résultant de l'insertion de la nervure principale 110. Les gorges 139 et 141 sont délimitées par des retours d'extrémité 145 et 147, qui permettent d'éviter tout risque d'extraction frontale des profilés souples cintrés 150 lors d'une ouverture un peu brutale de la porte.

Il va de soi que la conformation des espaces 115 et 117 recevant les bords d'extrémité 152 des profilés souples 150 pourra être telle que chacun des profilés soit tenu par élasticité, sans être nécessairement au contact l'un de l'autre lorsque la nervure principale 110 n'est pas insérée entre ceux-ci. La possibilité de prévoir des profilés souples cintrés formant lame ressort qui sont auto-portés dans l'espace intérieur 109 du profilé en U 101 est extrêmement intéressante dans la pratique, puisqu'elle permet d'éviter une fixation préliminaire par vissage ou collage à l'intérieur de cet espace, les profilés étant simplement insérés entre les deux branches latérales du profilé en U, soit en bout, soit frontalement. Cette caractéristique est naturellement d'autant plus intéressante que les profilés rencontrés sont de grande longueur, par exemple pour des profilés atteignant cinq mètres de long.

Il est par ailleurs avantageux de prévoir que le système de blindage 100 comporte au moins un joint d'étanchéité aux hyperfréquences. Contrairement aux systèmes de blindage connus, pour lesquels un tel joint d'étanchéité était logé au fond de l'espace central du profilé en U, on utilise ici une disposition extérieure plus accessible, et qui permet de faciliter la mise en place du ou des joints concernés.

Tout d'abord, on trouve un joint d'étanchéité 122 monté au fond d'une gorge 120 qui est définie par la nervure principale 110 et l'aile d'appui 108 du profilé 102. Ce joint 122, qui est par exemple collé au fond de sa gorge, est alors contacté, lorsque la porte est fermée, par le bord libre de la branche 105 du profilé en U 101, comme cela est visible sur la figure 1. On a également prévu ici un autre joint d'étanchéité 125, qui est monté sur une aile latérale 119 solidaire de la branche 107 du profilé en U 101, en étant reçu dans une gorge délimitée par deux petites nervures parallèles 121 et 123 (la gorge pourrait en variante être délimitée par l'extrémité de la branche 107 du profilé en U, et une seule nervure supplémentaire 121). Ce joint 125 est alors contacté lorsque la porte est fermé, par un rebord saillant 126 terminant une aile latérale 124 solidaire du profilé 102 qui porte la nervure principale 110. Chacun des joints d'étanchéité aux hyperfréquences précités 122 et 125 pourra être réalisé en caoutchouc avec des charges de carbone, ainsi que cela est classique dans la structure des cages de Faraday. Il va de soi que l'on pourra utiliser un seul des deux joints précités pour l'étanchéité aux hyperfréquences, l'autre joint, de conception classique, pourra alors servir notamment pour l'étanchéité à l'air et/ou à l'humidité, selon le type d'application concerné.

Lors de la fermeture de la porte, si l'on part d'une position correspondant à celle illustrée en figure 2, le mouvement du battant 202 dans le sens de la flèche 300 fait pénétrer progressivement la nervure principale 110 dans l'espace central 109 du profilé en U 101, et la portion d'extrémité effilée 116 de cette nervure vient s'insérer entre les deux profilés souples cintrés 150, jusqu'à la butée contre le ou les joints respectifs 122 et/ou 125. Dans cette position, qui correspond à celle de figure 1, l'espace intérieur 109 du profilé en U est occupé en grande partie par de la matière (nervure principale 110 avec sa portion de base large 112, et nervure centrale 113). En outre, dans cette position, la nervure principale 110 contacte chacun des profilés souples cintrés 150 au niveau d'une large plage de contact, concernant simultanément la portion intermédiaire 114 et la portion d'extrémité 116 de cette nervure principale. Ainsi, en plus de l'excellente étanchéité aux ondes électro-magnétiques, on obtient en même temps un bon contact électrique, ce qui est favorable pour la continuité électrique de part et d'autre de la feuillure de porte.

On est ainsi parvenu à réaliser un système de blindage de feuillure de porte permettant d'obtenir une excellente étanchéité aux ondes électro-magnétiques, tout en favorisant la qualité de la continuité électrique lorsque la porte est fermée, ce qui rend ce système tout spécialement intéressant dans le cas particulier des cages de Faraday. Le système de blindage précité comporte en outre une structure qui est à la fois simple, robuste, et aisée à assembler, même si les profilés concernés présentent une longueur importante (par exemple cinq mètres).

## Revendications

1. Système de blindage de feuillure de porte, notamment pour une porte de cage de Faraday, comportant deux profilés rigides homologues (101, 102) respectivement fixés au dormant et au battant, dont l'un (101) a une section en forme de U définissant un espace intérieur dans lequel pénètre, à la fermeture de la porte, une nervure principale (110) solidaire de l'autre profilé (102), ainsi que deux profilés souples cintrés (150) disposés dans ledit espace intérieur et entre lesquels vient s'insérer ladite nervure principale pour assurer la continuité électrique lorsque la porte est fermée, caractérisé par le fait que la nervure principale (110) présente une portion de base large (112) se raccordant par une portion intermédiaire (114) à une portion d'extrémité effilée (116), lesdites portions étant agencées de telle façon que, lorsque la porte est fermée, chacun des profilés souples cintrés (150) contacte simultanément la portion intermédiaire (114) et la portion d'extrémité (116) de la nervure principale (110).

2. Système de blindage selon la revendication 1, caractérisé par le fait que la portion intermédiaire (114) de la nervure principale (110) forme un raccordement progressif définissant une large plage de contact pour chacun des profilés souples cintrés (150).

3. Système de blindage selon la revendication 1 ou 2, caractérisé par le fait que les deux profilés souples cintrés (150) sont auto-portés dans l'espace intérieur (109) du profilé en U (101).

4. Système de blindage selon la revendication 3, caractérisé par le fait que le profilé en U (101) présente en outre une nervure centrale (113) au fond de l'espace central (109), de part et d'autre de laquelle passe un bord d'extrémité (152) de chacun des profilés souples cintrés (150), ladite nervure centrale assurant ainsi le maintien et le centrage desdits profilés souples cintrés.

5. Système de blindage selon revendication 4, caractérisé par le fait que la nervure centrale (113) est effilée depuis sa base (129), de façon à procurer un guidage facilitant une éventuelle mise en place frontale des profilés souples cintrés (150).

6. Système de blindage selon la revendication 4 ou 5, caractérisé par le fait que chaque profilé souple cintré (150) comporte une portion centrale de contact (151) qui est bombée, et deux bords d'extrémité (152, 154) dont l'un (152) est en appui contre la base (129) de la nervure centrale (113), tandis que l'autre (154) est reçu dans une gorge associée (139, 141) du profilé en U (101) prévue pour empêcher une extraction frontale dudit profilé souple cintré.

7. Système de blindage selon la revendication 6, caractérisé par le fait que les bords d'extrémité (152, 154) de chaque profilé souple cintré (150) sont relevés, de façon à définir au niveau des pliages correspondants deux arêtes longitudinales (155, 156) d'appui et de contact.

8. Système de blindage selon l'une des revendications 1 à 7, caractérisé par le fait qu'il comporte au moins un joint (122, 125) d'étanchéité aux hyperfréquences.

9. Système de blindage selon la revendication 8, caractérisé par le fait qu'il comporte un joint d'étanchéité (122) monté au fond d'une gorge (120) définie par la nervure principale (110) et une aile d'appui (108) du profilé correspondant (102), ledit joint étant alors contacté, lorsque la porte est fermée, par une branche (105) du profilé en U (101).

10. Système de blindage selon la revendication 8 ou 9, caractérisé par la fait qu'il comporte un joint d'étanchéité (125) monté sur une aile latérale (119) solidaire d'une branche (107) du profilé en U (101), ledit joint étant alors contacté, lorsque la porte est fermée, par un rebord saillant (126) du profilé (102) portant la nervure principale (110).

## Patentansprüche

1. System zur Abschirmung eines Türfalzes, insbesondere für die Tür eines Faradaykäfigs, mit zwei homologen starren Profilen (101,102), die am Türrahmen bzw. am Türflügel befestigt sind, wovon das eine (101) einen U-förmigen Querschnitt hat, der einen Innenraum definiert, in welchen beim Schließen der Tür eine mit dem anderen Profil (102) fest verbundene Hauptrippe (110) eindringt, sowie mit zwei elastischen Bogenprofilen (150), die in dem genannten Innenraum angeordnet sind und zwischen welche sich die Hauptrippe schiebt, um die elektrische Leitfähigkeit bei geschlossener Tür sicherzustellen, dadurch gekennzeichnet, daß die Hauptrippe (110) einen breiten Basisabschnitt (112) hat, der sich über einen Zwischenabschnitt (114) an einen verjüngten Endabschnitt (116) anschließt, wobei die genannten Abschnitte derart ausgebildet sind, daß jedes der elastischen Bogenprofile (150) beim Schließen der Tür mit dem Zwischenabschnitt (114) und zugleich mit dem Endabschnitt (116) der Hauptrippe (110) in Kontakt gelangt.

2. Abschirmsystem nach Anspruch 1, dadurch gekennzeichnet, daß der Zwischenabschnitt (114) der Hauptrippe (110) einen progressiven Übergang bildet, der einen großen Kontaktbereich für jedes der elastischen Bogenprofile (150) definiert.

3. Abschirmsystem nach Anspruch 1 oder 2, dadurch gekennzeichnet, daß die beiden elastischen Bogenprofile (150) in dem Innenraum (109) des U-Profils (101) selbsttragend sind.

4. Abschirmsystem nach Anspruch 3, dadurch gekennzeichnet, daß das U-Profil (101) am Boden des zentralen Raumes (109) ferner eine zentrale Rippe (113) aufweist, auf deren beiden Seiten ein Endrand (152) jedes elastischen Bogenprofils (150) verläuft, so daß die zentrale Rippe infolgedessen die Haltung und Zentrierung der elastischen Bogenprofile (150) sicherstellt.

5. Abschirmsystem nach Anspruch 4, dadurch gekennzeichnet, daß die zentrale Rippe (113) ausgehend von ihrer Basis derart verjüngt ist, daß eine Führung geschaffen wird, die ein eventuelles stirnseitiges Einsetzen der elastischen Bogenprofile (150) erleichtert.

6. Abschirmsystem nach Anspruch 4 oder 5, dadurch gekennzeichnet, daß jedes elastische Bogenprofil (150) einen zentralen Kontaktabschnitt (151), der gewölbt ist, und zwei Endränder (152,154) hat, wovon sich der eine (152) an der Basis (129) der zentralen Rippe (113) abstützt, während der andere (154) in einer zugehörigen Vertiefung (139,141) des U-Profils (101) aufgenommen ist, die vorgesehen ist, um ein stirnseitiges Herausziehen des genannten elastischen Bogenprofils zu verhindern.

7. Abschirmsystem nach Anspruch 6, dadurch gekennzeichnet, daß die Endränder (152,154) jedes elastischen Bogenprofils (150) derart hochgezogen sind, daß sie auf Höhe entsprechender Falzungen zwei Längskanten (155,156) für die Abstützung und den Kontakt bilden.

8. Abschirmsystem nach einem der Ansprüche 1 bis 7, gekennzeichnet durch zumindest eine Dichtung (122,125) zur Abdichtung gegen Ultrahochfrequenzen.

9. Abschirmsystem nach Anspruch 8, gekennzeichnet durch eine Dichtungsfuge (122), die am Boden einer durch die Hauptrippe (110) und einen Stützflügel (108) des entsprechenden Profils (102) begrenzten Vertiefung (120) befestigt ist, so daß die Dichtung bei geschlossener Tür folglich von einem Schenkel (105) des U-Profils (101) kontaktiert wird.

10. Abschirmsystem nach Anspruch 8 oder 9, gekennzeichnet durch eine Dichtung (125), die an einem mit einem Schenkel (107) des U-Profils (101) fest verbundenen Seitenflügel (119) befestigt ist, so daß die Dichtung bei geschlossener Tür folglich von einem nach außen vorstehenden Rand (126) des die Hauptrippe (110) tragenden Profils (102) kontaktiert wird.

## Claims

1. A door rabbet shielding system, in particular for a Faraday cage door, comprising two homologous rigid shaped members (101, 102) which are respectively fixed to the door frame and to the door leaf and of which one (101) is of a U-shaped section defining an internal space into which a main rib (110) which is fixed to the other shaped member (102) passes upon closure of the door, and two curved flexible shaped members (150) which are disposed in said internal space and between which said main rib canes to be inserted to ensure electrical continuity when the door is closed, characterised in that the main rib (110) has a wide base portion (112) which is connected by an intermediate portion (114) to a tapered end portion (116), said portions being arranged in such a way that, when the door is closed, each of the curved flexible shaped members (150) simultaneously contacts the intermediate portion (114) and the end portion (116) of the main rib (110).

2. A shielding system according to claim 1 characterised in that the intermediate portion (114) of the main rib (110) forms a progressive connection defining a wide contact area for each of the curved flexible shaped members (150).

3. A shielding system according to claim 1 or claim 2 characterised in that the two curved flexible shaped members (150) are self-supported in the internal space (109) of the U-shaped member (101).

4. A shielding system according to claim 3 characterised in that the U-shaped member (101) also has a central rib (113) at the bottom of the central space (109), on respective sides of which central rib passes an end edge (152) of each of the curved flexible shaped members (150), said central rib thus ensuring that said curved flexible shaped members are held in position and centered.

5. A shielding system according to claim 4 characterised in that the central rib (113) is tapered from its base (129) so as to provide a guidance action for facilitating possible frontal fitment of the curved flexible shaped members (150).

6. A shielding system according to claim 4 or claim 5 characterised in that each curved flexible shaped member (150) comprises a central contact portion (151) which is dished, and two end edges (152, 154) of which one (152) bears against the base (129) of the central rib (113) while the other (154) is received in an associated groove (139, 141) of the U-shaped member (101), which groove is provided to prevent frontal extraction of said curved flexible shaped member.

7. A shielding system according to claim 6 characterised in that the end edges (152, 154) of each curved flexible shaped member (150) are raised so as to define at the level of the corresponding bends two longitudinal support and contact ridges (155, 156).

8. A shielding system according to one of claims 1 to 7 characterised in that it comprises at least one seal (122, 125) for sealing integrity in relation to very and ultra high frequencies.

9. A shielding system according to claim 8 characterised in that it comprises a seal (122) mounted at the bottom of a groove (120) defined by the main rib (110) and a support limb (108) of the corresponding shaped member (102), said seal then being contacted when the door is closed by a leg (105) of the U-shaped member (101).

10. A shielding system according to claim 8 or claim 9 characterised in that it comprises a seal (125) mounted on a lateral limb (119) which is fixed with respect to a leg (107) of the U-shaped member (101), said seal then being contacted when the door is closed by a projecting edge (126) of the shaped member (102) which bears the main rib (110).
